# EUROPÄISCHE PATENTSCHRIFT

(11) **EP 3 476 186 B1**
(45) Veröffentlichungstag und Bekanntmachung des Hinweises auf die Patenterteilung: **15.04.2020**
(21) Anmeldenummer: 17728510.3
(22) Anmeldetag: 01.06.2017
(51) Int. Cl.: H05K 5/00

(54) **ELEKTRONIKEINHEIT UND VERFAHREN ZUR AUSBILDUNG EINER ELEKTRONIKEINHEIT**
ELECTRONIC UNIT AND METHOD FOR MANUFACTURING AN ELECTRONIC UNIT
UNITÉ ÉLECTRONIQUE ET PROCÉDÉ DE FABRICATION D'UNE UNITÉ ÉLECTRONIQUE

(30) Priorität: 28.06.2016 DE 102016211637
(43) Veröffentlichungstag der Anmeldung: 01.05.2019
(73) Patentinhaber: Robert Bosch GmbH, 70442 Stuttgart (DE)
(72) Erfinder: WIESA, Thomas, 71665 Vaihingen (DE); HENNEL, Udo, 74343 Sachsenheim (DE); DOEHREN, Stefan, 73630 Remshalden-Grunbach (DE)
(86) Internationale Anmeldenummer: PCT/EP2017/063296
(87) Internationale Veröffentlichungsnummer: WO 2018/001676

(56) Entgegenhaltungen:
- EP-A1- 1 643 818
- EP-A1- 2 265 102
- DE-A1- 1 912 635
- US-A1- 2009 086 454

## Beschreibung

Die Erfindung betrifft eine Elektronikeinheit sowie ein Verfahren zur Ausbildung einer Elektronikeinheit gemäß den Oberbegriffen der unabhängigen Ansprüche.

### Stand der Technik

Im Betrieb sind Elektronikeinheiten einer Vielzahl von störenden oder die Elektronik schadenden Einflüssen ausgesetzt. Es sind verschiedene Schutzeinrichtungen bekannt, welche derartige Einflüsse reduzieren oder ganz unterbinden. Eine einfache Möglichkeit ist dadurch gegeben, dass die Elektronikeinheit ein Gehäuse umfasst, welches eine zu schützende schaltungstragende Leiterplatte im Inneren aufnimmt. Das Gehäuse ist dabei in der Regel mehrteilig ausgeführt, beispielsweise mit einem Boden-und Deckelteil. In einem Montagevorgang wird die Leiterplatte innerhalb des Gehäusebodens befestigt. Mittels am Gehäuse befindlichen Verschlusselementen sowie gegebenenfalls vorgesehenen Dichtelementen kann die Leiterplatte schützend umhaust werden. Dabei müssen elektrische Anschlusskontakte durch das Gehäuse durchgeführt werden.

Aus der Offenlegungsschrift DE 1912 635 A1 ist eine Hochspannungsversorgung bekannt, bei welcher elektrische Bauteile in einem Becher montiert sind. Größere freie Hohlräume zwischen den elektrischen Bauteilen werden durch eine Vielzahl von losen und räumlich zufällig verteilten Keramikkugeln ausgefüllt. Der verbleibende Freiraum im Becher ist mit einer Vergussmasse aus Silikon-Kautschuk ausgegossen. Die Vergussmasse setzt die Überschlagsweite der elektrischen Spannung herab und schützt die eingebetteten elektronischen Bauteile vor Feuchtigkeit. Ein Deckel schließt den Becher an seiner freien Stelle ab. Beim Vergießen können die Keramikkugeln eine undefinierte Lage innerhalb des Bechers einnehmen und dabei dann in einer inhomogenen Verteilung vorliegen.

Ferner beschreibt die Offenlegungsschrift DE 4237 870 A1 ein Steuergerät für ein Kraftfahrzeug. Hierbei wird als Träger der elektronischen Schaltung eine wenigstens einseitig mit Bauelementen bestückte Leiterplatte verwendet. Die bestückte Leiterplatte ist durch ein Tauch-, Sprüh-oder Beflockungsprozess von einer konturschlüssig anliegenden, elektrisch hochisolierenden Umhüllung umgeben. In einem weiteren Verfahren ist um die Umhüllung zusätzlich ein Formschaum aufgebracht, durch welchen die äußere Kontur des Steuergerätes bestimmt ist.

### Offenbarung der Erfindung

Der Erfindung liegt die Aufgabe zu Grunde, einen wirksamen Schutz einer Elektronikeinheit unter Minimierung von Einzelteilen und Fertigungsprozessen vorzuschlagen.

Diese Aufgabe wird durch eine Elektronikeinheit sowie ein Verfahren zur Ausbildung einer Elektronikeinheit mit den kennzeichnenden Merkmalen der unabhängigen Ansprüche gelöst.

Die Erfindung geht aus von einer Elektronikeinheit umfassend zumindest eine ein- oder zweiseitig mit einer Vielzahl von elektrisch und/oder elektronischen Bauelementen bestückten Leiterplatte. Zum Schutz vor äußeren Einflüssen - wie zum Beispiel Feuchtigkeit, mechanischen Stoßeinwirkungen und/oder einer Kurzschlusskontaktierung -ist die bestückte Leiterplatte zumindest in einer Schutzumhausung aus einer verfestigten Vergussmasse eingebettet. Als Vergussmasse eignen sich beispielsweise Materialien wie Epoxide oder Polyurethane. Die Elektronikeinheit ist insgesamt als ein Volumenkörper ausgebildet. Dieser ist durch eine äußere Formgestalt begrenzt und umschließt anwendungsspezifisch ein Formbestimmtes räumliches Volumen ein. Ein Teil dieses umschlossenen Volumens ist hierbei durch die bestückte Leiterplatte belegt. Darüber hinaus nimmt die verfestigte Vergussmasse einen weiteren Teil des umschlossenen Volumens, insbesondere einen verbleibenden Restteil, in Form eines Füllvolumens ein. Ein maximal vorliegendes Füllvolumen hängt dabei von verschiedenen Faktoren ab. Zum einen können die auf der bestückten Seite der Leiterplatte angeordneten elektrischen und/oder elektronischen Bauelemente in unterschiedlichen Abständen zueinander angeordnet sein. Des Weiteren können die so angeordneten elektrischen und/oder elektronischen Bauelemente verschieden stark von der Leiterplattenseite abstehen bzw. herausragen. Gerade große und weit abstehende elektrische und/oder elektronische Bauelemente bestimmen wiederrum die äußersten Randbereiche eines möglichen auszuformenden Volumenkörpers der Elektronikeinheit. Schlussendlich ist ein maximales Füllvolumen dann festgelegt durch eine im Mittel über die einzubettende Leiterplatte festgelegte einfache Formgestalt des zu bestimmenden Volumenkörpers. Anwendungsspezifisch kann daher zur Ausbildung einer Schutzumhausung eine große Füllmenge an Vergussmasse notwendig sein. Ferner können sich dabei noch lokal ausgeprägte Anhäufungen an Vergussmasse ausbilden. Zur Minimierung des Füllvolumens für die Vergussmasse umfasst die Elektronikeinheit daher zusätzlich ein separates Einlegeformteil. Dieses ist zumindest angrenzend zu einer bestückten Seite der zumindest einen Leiterplatte angeordnet. Eine Minimierung ergibt sich hierbei dadurch, dass das Einlegeformteil gegenüber einer fließfähigen Vergussmasse zur Ausbildung der Schutzumhausung in einem verfestigten Zustand ein räumlich geschlossenes Verdrängungsvolumen im Volumenkörper einnimmt. Im Ergebnis kann dadurch in vorteilhafter Weise zum einen die Füllmenge an Vergussmasse im Volumenkörper variabel festgelegt werden, insbesondere auf eine Mindestmenge reduziert werden, wodurch sich deutliche Kostenersparnisse in der Herstellung ergeben. Indem das Einlegeformteil ein räumlich geschlossenes Verdrängungsvolumen darstellt, ist eine definierte und insbesondere gleichbleibende Anordnung relativ zur Leiterplatte auch während eines Fertigungsprozesses der Schutzumhausung gegeben. Auf diese Weise erhält man den großen Vorteil, dass die Stellen genau festlegbar sind, an denen die Vergussmasse im Volumenkörper vorliegen soll. Mitunter können diese Stellen durch eine besonders vorteilhafte Ausformung des Einlegeformteils derart bestimmt sein, dass fertigungstechnische Anforderungen zur Ausbildung der Schutzumhausung durch die Vergussmasse optimal berücksichtigt sind. Eine Berücksichtigung ist beispielsweise die Sicherstellung von stauungsfreien Fließwegen für die fließfähige Vergussmasse während des Herstellungsprozesses. Ebenso können Einfallsstellen an der verfestigten Vergussmasse reduziert oder ganz vermieden werden, beispielsweise durch eine an das Verfestigungsverhalten der Vergussmasse angepasste zulässige lokale Anhäufung innerhalb des Volumenkörpers. Eine einfache Festlegung von fertigungstechnischen Anforderungen können aus einer computerunterstützten Vergusssimulation in Hinblick auf das verwendete Material erfolgen oder alternativ durch eine Prototypenfertigung. Bevorzugt ist das Einlegeformteil formstabil gestaltet, insbesondere in einem Maße, dass allgemeine Fertigungstoleranzen hinsichtlich der Ausbildung der Schutzumhausung eingehalten werden können.

Durch die in den abhängigen Ansprüchen aufgeführten Maßnahmen sind vorteilhafte Weiterbildungen und Verbesserungen des erfindungsgemäßen Verfahrens möglich.

Eine besondere Kosten- und Fertigungsoptimierung liegt dann vor, wenn das Verdrängungsvolumen mindestens so groß ist wie das Füllvolumen, bevorzugt mehr als zweimal so groß.

Die bestückte Seite der zumindest einen Leiterplatte weist eine Bestückungstopologie auf, welche durch die von der bestückten Seite abstehenden elektrischen und/oder elektronischen Bauelemente gekennzeichnet ist. In einer bevorzugten Ausführungsform ist eine der bestückten Seite der Leiterplatte zugewandte Seite des Einlegeformteils an die Bestückungstopologie angepasst. Gerade bei Bestückungstopologien, bei denen große Höhen- und/oder Abstandsmaßunterschiede der elektrischen und/oder elektronischen Bauelemente untereinander vorliegen, sind große Raumvolumen zwischen einzelnen oder mehreren benachbarten elektrischen und/oder elektronischen Bauelementen zwangsweise gegeben. Durch ein Nachziehen der Außenkontur des Einlegeformteils in Richtung der Bestückungstopologie kann anwendungsspezifisch ein nicht unerheblicher Anteil des Füllvolumens für die Vergussmasse reduziert werden. Eine Anpassung an jedes einzelne elektrische und/oder elektronische Bauelement ist möglich, jedoch nicht grundsätzlich in der Gesamtheit erforderlich. Eine pragmatische Anpassung orientiert sich hierbei an einer geeigneten Auswahl einer Gruppe von benachbarten elektrischen und/oder elektronischen Bauelementen mit einem innerhalb eines Wertebereichs liegendem Höhen- und/oder Abstandsmaß. Beispielhaft könnte ein vorteilhafter Wertebereich - ausgehend von den elektrischen und/oder elektronischen Bauelementen mit dem kleinsten und/oder größten Höhenmaß innerhalb der ausgewählten Gruppe - kleiner oder gleich 5 mm, bevorzugt kleiner oder gleich 3 mm, aufweisen. Die Anpassung ergibt sich dann lokal durch ein Nachziehen des Einlegeformteils bis maximal auf das elektrische und/oder elektronische Bauelement mit der größten Bauteilhöhe innerhalb der ausgewählten Gruppe.
Grundsätzlich kann durch eine solche Anpassung der der bestückten Seite zugewandten Seite des Einlegeformteiles an die Bestückungstopologie eine positionsrichtige Anordnung des Einlegeformteiles relativ zur Leiterplatte erleichtert werden. Des Weiteren ist ein Verrücken einer solchen Anordnung erschwert. Eine weitere Verbesserung diesbezüglich ergibt sich, wenn das Einlegeformteil Fixierbereiche aufweist. Ein solcher Fixierbereich kann beispielsweise als eine Vertiefung innerhalb des Einlegeformteils vorliegen, in welche dann zumindest ein elektrisches und/oder elektronisches Bauelement teilweise oder nahezu vollständig eintaucht und dadurch eine laterale Verschiebung des Einlegeformteil behindert. Bei großen und/oder formeinfachen elektrischen und/oder elektronischen Bauelementen, wie beispielsweise Elektrolytkondensatoren, kann die Wandung der zuvor genannten Vertiefung an das elektrische und/oder elektronische Bauelement anliegen und dieses klemmend umschließen. Alternativ ist ein Fixierbereich lediglich als ein lokal abstehendes Formelement am Einlegeformteil ausgeformt, welches zumindest mit einem Teilbereich seitlich zu zumindest einem elektrischen und/oder elektronischen Bauelement benachbart ist und durch unmittelbares Anstoßen an dieses eine Bewegungsmöglichkeit in zumindest eine Richtung blockt. Das abstehende Formelement kann zusätzlich einen Klemmbereich aufweisen, welches das elektrische und/oder elektronische Bauelement seitlich zumindest teilweise umfasst.

In einer vorteilhaften Ausführungsform ist zwischen dem Einlegeformteil und der angrenzenden bestückten Seite der zumindest einen Leiterplatte ein Spaltabstand derart ausgebildet, dass die auf der bestückten Seite der Leiterplatte angeordneten elektrischen und/oder elektronischen Bauelemente vollständig von der Vergussmasse eingeschlossen sind. Selbst bei einer großen Bestückungsdichte der Leiterplatte ist dadurch in vorteilhafter Weise für die Vergussmasse im fließfähigen Zustand ein staufreier Flussweg sichergestellt, sodass alle elektrischen und/oder elektronischen Bauelemente von der Vergussmasse erreichbar sind. Der Spaltabstand kann in einfacher Weise erhalten werden, indem das Einlegeformteil beispielsweise abstehende Auflagedome aufweist. Mittels diesen kann das Einlegeformteil zwischen den elektrischen und/oder elektronischen Bauelementen hindurch auf dann bauteilfreie Leiterplattenbereiche aufliegen. Alternativ kann ein einzelner Auflagedom oder mehrere davon sich jeweils auf einem elektrischen und/oder elektronischen Bauelement abstützen.

Ein besonders großer Vorteil ergibt sich bei einer Ausführungsform, bei welcher in einer Draufsicht auf eine bestückte Seite der zumindest einen Leiterplatte das Einlegeformteil mehr als die Hälfte der Leiterplatte überdeckt, bevorzugt in einer Überdeckung von 70% bis 100%. Dadurch ist eine maximale Reduzierung des Füllvolumens für die Vergussmasse zu erreichen.

Eine besondere Ausführungsform der Elektronikeinheit umfasst zwei übereinander angeordnete ein- oder zweiseitig bestückte Leiterplatten. Bevorzugt ist dann das Einlegeformteil zwischen beiden Leiterplatten angeordnet. Der durch die Beabstandung der Leiterplatten ansonsten vorliegende Volumenraum ist an für sich fertigungstechnisch für eine Vergussmasse schlecht zugänglich und kann auf diese Weise einfach umgangen werden. Zusätzlich übernimmt das Einlegeformteil die Funktion eines Abstandshalters zur definierten Einstellung einer Beabstandung beider Leiterplatten zueinander.

Eine ebenso vorteilhafte Ausführungsform ergibt sich, wenn die zumindest eine Leiterplatte beidseitig bestückt ist und zu beiden bestückten Seiten der Leiterplatte jeweils angrenzend ein Einlegeformteil angeordnet ist. Somit ist die Reduzierung eines Füllvolumens für die Vergussmasse nicht nur auf eine bestückte Leiterplattenseite hin beschränkt, wodurch verschiedenste Ausführungsformen von Elektronikeinheiten profitieren können. Grundsätzlich sind daher Ausführungen von Elektronikeinheiten denkbar, welche eine oder mehrere, insbesondere übereinander angeordnete ein- oder beidseitig bestückte Leiterplatten umfassen. Dabei ist bei Bedarf bei zumindest einer bis hin zu allen vorliegenden Leiterplatten jeweils auf einer und/oder auf beiden Bestückungsseiten der jeweiligen Leiterplatte ein Einlegeformteil angrenzend angeordnet.

Bevorzugt ist das Einlegeformteil einstückig ausgebildet. Dadurch ist es vorteilhaft möglich, ein räumlich geschlossenes Verdrängungsvolumen für eine fließfähige Vergussmasse sehr einfach umzusetzen und sicherzustellen. Dabei können unterschiedlichste Formgestaltungen fertigungstechnisch berücksichtigt sein. Grundsätzlich ist dabei vorteilhaft, dass Krafteinwirkungen, beispielsweise infolge von Umfließen durch eine Vergussmasse, gegenüber einem gesamtheitlich zusammenhängenden Formkörper erfolgen. Somit ist das Verhalten des Einlegeformteiles beim Umgießen mit Vergussmasse leicht vorhersehbar sowie dessen Auslegung hinsichtlich einer Formstabilität günstig festzulegen. Alternativ bietet sich an, das Einlegeformteil als einen zusammenhängenden Formteilverbund vorzusehen. Dieser weist eine Gruppe von gleichartigen und/oder verschiedenartigen Körperelementen auf, welche kraft-, form- und/oder stoffschlüssig einen Verbund ausbilden. Dieser entspricht in seinem Verhalten und seinen Eigenschaften dem oben beschriebenen einstückigen Einlegeformteil. Die Körperelemente können beispielsweise sehr einfache Grundkörper bilden, welche aus einem günstigen Stangenmaterial abgelängt sind und über ihre Körperelementseiten miteinander verbunden sind. Durch unterschiedliche Ablängungen können die Körperelemente im Verbund dann verschieden stark in eine Richtung abstehen und beispielsweise eine Anpassung an eine Bestückungstopologie der zumindest einen Leiterplatte abbilden. An den Körperelementseiten können Verbindungsabschnitte vorliegen, die bei zumindest zwei benachbart angeordneten Körperelementen komplementär zueinander ausgebildet sind. Die Verbindungsabschnitte bilden dabei beispielsweise eine Schnappverbindung aus, so dass sich der Formteilverbund durch einen Kraft- und/oder Formschluss an den Verbindungsabschnitten ergibt. Die komplementären Verbindungsabschnitte können alternativ auch ein Feder-Nut-System darstellen, durch welches das eine Körperelement mit einem Federelement in ein Nutelement eines benachbarten Körperelements eingreift. Dabei ist eine Längsverschiebung entlang einer geradlinig gerichteten Erstreckungsachse des Feder- bzw. Nutelements ermöglicht. Das Federelement ist dann durch das Nutelement zumindest derart umgriffen, dass ein Formschluss ausgebildet ist und eine Verschiebung der den Formteilverbund ausbildenden Körperelemente außer entlang der zuvor genannten Erstreckungsachse nicht mehr zulässt. Indem der Formschluss zusätzlich so ausgelegt ist, dass eine leichte Klemmwirkung vorliegt, ist eine Verschiebung des Körperelements innerhalb eines Formteilverbundes im Formzustand für einen Montagevorgang ausreichend gegen eine unbeabsichtigte relative Verschiebung einzelner Körperelemente ausreichend fixiert.

Eine bevorzugte Ausführungsform sieht vor, dass das Einlegeformteil ein Hohlformkörper oder ein Formschaumkörper ist. In beiden Fällen ergibt sich der Vorteil, dass eine Elektronikeinheit mit nur geringem Gewicht erhalten werden kann. Durch die Reduzierung des Füllvolumens für die Vergussmasse ist diese durch eine viel leichtgewichtigere Masse des Einlegeformteils ersetzt.

Grundsätzlich ist ein besonderer Vorteil darin gegeben, dass mittels des Einlegeformteils eine definierte Formgestalt des Volumenkörpers umgesetzt werden kann. Eine solche Formgestalt kann beispielsweise funktionstechnisch bedingt sein, beispielsweise um die Elektronikeinheit an einen bestimmten Einbauraum anzupassen und/oder eine Handhabung zu unterstützen. Ebenso kann aus Vertriebsgründen eine bestimmte Formensprache gefordert sein. Eine Formgestalt ist im Prinzip sehr beliebig ausführbar, auch derart, dass zwischen der zumindest einen enthaltenen ein- oder beidseitig bestückten Leiterplatte und einer Körperaußenfläche der Elektronikeinheit eine große Beabstandung vorliegt. Dieser dadurch bedingte Volumenraum ist sehr einfach durch einen entsprechen raumeinnehmenden Teilbereich des Einlegeformteils auszufüllen. Dadurch ist ein ansonsten bedingtes großes Füllvolumen für die Vergussmasse in vorteilhafter Weise beliebig zu reduzieren. Eine sehr einfache Formgestalt für die Elektronikeinheit ergibt sich dann, wenn der Volumenkörper und/oder das Einlegeformteil jeweils als ein Polyeder ausgebildet ist/sind, das heißt alle Körperaußenflächen sind aus ebenen Flächenstücken gebildet. Dadurch ist eine Herstellung der Elektronikeinheit kosten- und fertigungsgünstig auszuführen, insbesondere hinsichtlich eines erforderlichen dann sehr einfachen Werkzeugs für das Einbringen der Vergussmasse zur Ausbildung einer Schutzumhausung einerseits, als auch für die Herstellung des Einlegeformteils selbst. In diesem Sinne sind Formgestalten wie ein Würfel, Quader, Tetraeder, Pyramide, Pyramidenstumpf oder Oktaeder besonders vorteilhaft. Daneben gibt es weitere einfache Formgestalten wie z.B. ein Rotationskörper, Kugel, Kugelkalotte, Zylinder, Ellipsoid, Kegel oder Kegelstumpf. Darüber hinaus ist die Umsetzung eines Volumenkörpers möglich, welcher aus zumindest zwei der zuvor genannten Formgestalten zusammengesetzt ist. Schlussendlich kann der Volumenkörper vollständig oder zumindest partiell gekrümmte Körperaußenflächen aufweisen, was gegebenenfalls werkzeugseitig einen größeren Aufwand bedingt.

Eine vorteilhafte Ausführungsform sieht vor, dass der Volumenkörper zumindest einen Außenflächenteil aufweist, welcher durch einen Teilbereich des Einlegeformteils gebildet ist. Demnach ist es nicht mehr erforderlich, dass die Elektronikeinheit von außen vollständig von einer verfestigten Vergussmasse umschlossen ist, wodurch eine weitere Einsparung hinsichtlich einer Füllmenge an Vergussmasse erzielbar ist. Des Weiteren kann der genannte Teilbereich des Einlegeformteils vorteilhaft besondere mechanische und/oder elektrische Funktionsbereiche aufweisen, welche durch eine Umsetzung durch eine Vergussmasse schwer oder nur mit mehr Aufwand zu realisieren ist. So kann der Teilbereich des Einlegeformteils Befestigungselemente umfassen als Befestigungsmöglichkeit der Elektronikeinheit mit einem Halter.

Grundsätzlich umfasst die Elektronikeinheit einen Anschlussbereich, welcher die elektrische Kontaktierung der Leiterplatte ermöglicht. Vorteilhaft ist der Anschlussbereich in Form eines Anschlusssteckers ausgeführt, welcher mit der Leiterplatte elektrisch kontaktiert ist und von außerhalb des Volumenkörpers durch einen Gegenstecker kontaktierbar ist. Der Anschlussbereich bzw. der Anschlussstecker kann hierbei zum einen durch eine von verfestigten Vergussmasse gebildeten Körperaußenfläche des Volumenkörpers austreten. Zum anderen ist das Vorsehen des Anschlussbereiches bzw. des Anschlusssteckers innerhalb des zuvor genannten Teilbereichs des Einlegeformteils möglich, welcher zumindest einen Außenflächenbereich des Volumenkörpers bildet.

Grundsätzlich ist eine Vielzahl von Materialien für das Einlegeformteil möglich. Die Auswahl richtet sich unter anderem nach einer vorrangigen Eigenschaft, beispielsweise einem geringen Gewicht, einfachen Fertigungsmöglichkeiten, Stoßabsorptionsvermögen, geringem oder einem ganz bestimmten Ausdehnungsverhalten, usw.. Um gegebenenfalls eine günstige Entwärmung der Elektronikeinheit zu unterstützen, kann das Einlegeformteil metallisch ausgeführt sein. Es ist hierbei darauf zu achten, dass eine Kurzschlusskontaktierung gegenüber der Leiterplatte durch eine ausreichende Beabstandung ausgeschlossen bleibt. Diese lässt sich ferner dadurch ausschließen, indem die Vergussmasse die Funktion einer elektrischen Isolierung erfüllt und die bestückte Leiterplatte umhüllt. Eine andere Möglichkeit bietet sich dadurch, dass das Einlegeformteil aus einem elektrisch isolierendem Material ist. Sehr kostengünstige Einlegeformteile können durch ein Elastomer- oder ein Duroplastmaterial gefertigt werden. Insgesamt sind Fertigungsverfahren zur Herstellung des Einlegeformteils bevorzugt, welche im Rahmen hoher Stückzahlanforderungen eine besonders kostengünstige Fertigung ermöglichen. Je nach ausgewähltem Material kommt hierfür beispielsweise ein Spritzgussverfahren, ein Extrusionsblasformverfahren, ein Schäumungsverfahren oder ein Pressverfahren in Frage.

Die Erfindung führt auch zu einem Verfahren zur Ausbildung einer Elektronikeinheit, insbesondere nach einem der vorhergehend beschriebenen Ausführungsformen, umfassend zumindest eine ein- oder zweiseitig mit einer Vielzahl von elektrisch und/oder elektronischen Bauelementen bestückte Leiterplatte mit den Verfahrensschritten:
- Einlegen der zumindest einen Leiterplatte zusammen mit einem Einlegeformteil in ein einen Volumenkörper der Elektronikeinheit ausformendes Werkzeug, wobei das Einlegeformteil angrenzend zu der zumindest einen bestückten Seite angeordnet wird und im Werkzeug ein Freiraum als Füllvolumen für eine Vergussmasse verbleibt,
- Einbringen einer fließfähigen Vergussmasse in das Werkzeug bis zum vollständigen Ausfüllen des Füllvolumens durch Vergussmasse,
- Ausbilden einer Schutzumhausung, in welcher die Leiterplatte eingebettet ist, indem die Vergussmasse verfestigt wird und die verfestigte Vergussmasse zumindest einen Teil der Außenfläche des Volumenkörpers ausbildet.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
Fig. 1a - 1d: die Ausbildung einer ersten Ausführungsform einer Elektronikeinheit zu verschiedenen Fertigungszeitpunkten,
Fig. 2a - 2d: die Ausbildung einer weiteren Ausführungsform einer Elektronikeinheit zu verschiedenen Fertigungszeitpunkten.

### Ausführungsformen der Erfindung

In den Figuren sind funktional gleiche Bauteile jeweils mit gleichen Bezugszeichen gekennzeichnet.

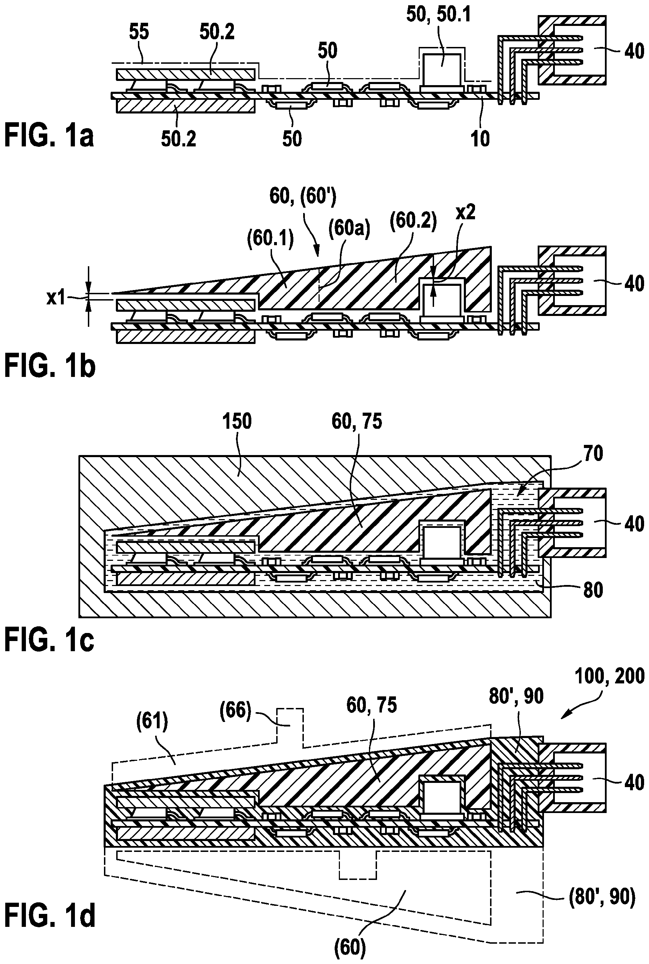

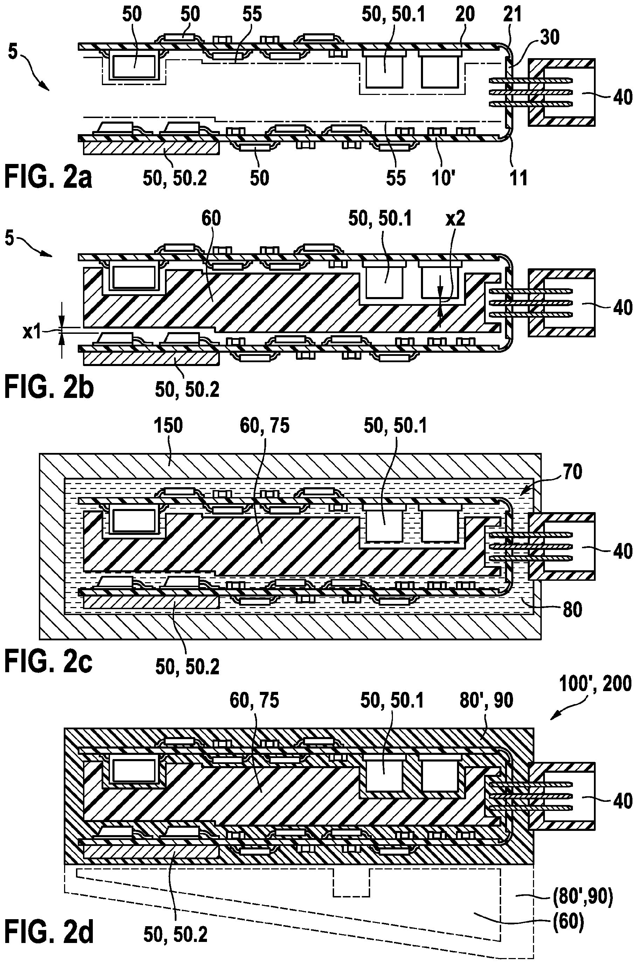

Die Figuren la - ld sowie die Figuren 2a - 2d zeigen jeweils die Ausbildung einer ersten bzw. einer weiteren Ausführungsform einer Elektronikeinheit 100, 100' zu verschiedenen Fertigungszeitpunkten. Im Einzelnen ist in den Figuren 1a und 2a jeweils die Bereitstellung einer bestückten Leiterplatte 10 bzw. einer Anordnung 5 aus einer Leiterplatte 10' und einer über diesen in einer Beabstandung parallel angeordneten weiteren Leiterplatte 20 gezeigt. Im vorliegenden Beispiel sind die beiden Leiterplatten 10', 20 über flexible Teilbereiche 11, 21 elektrisch miteinander verbunden. Derartige Leiterplattenausführungen sind allgemein beispielsweise als Starflex- oder Semiflexausführungen bekannt und ermöglichen eine flexible Winkelanordnung der Leiterplatten 10', 20 zueinander. Alternativ umfasst die Anordnung 5 gemäß der Fig. 2a zusätzlich einen in einer Steckerleiterplatte 30 kontaktierten Anschlussstecker 40. Dieser ist beispielsweise Teil der Starflex- oder Semiflexausführung und über die flexiblen Teilbereiche 11, 21 jeweils mit der Leiterplatte 10' bzw. der Leiterplatte 20 elektrisch verbunden. Die Steckerleiterplatte 30 ist dann beispielsweise senkrecht zu den beiden Leiterplatten 10', 20 orientiert, so dass eine Anschlussmöglichkeit in Richtung der Erstreckung der beiden Leiterplatten 10', 20 vorliegt. Alternativ könnte auch der Anschlussstecker 40 direkt mit einer Schaltungsstruktur der Leiterplatte 10' kontaktiert sein - insbesondere über lötverbundene Pinkontakte des Anschlusssteckers 40. Eine solche Kontaktierung ist in der Ausführung gemäß der Fig. la gezeigt. Grundsätzlich kann es sich bei den Leiterplatten 10, 10', 20 jeweils um eine ein- oder beidseitig bestückte Leiterplatte handeln. Auf der dann bestückten Leiterplattenseite sind eine Vielzahl von elektrischen und/oder elektronischen Bauelementen 50, 50.1, 50.1 angeordnet und bilden zusammen mit einer Leiterbahnstruktur eine elektrische Schaltung aus. Die elektrische Schaltung umfasst in den vorliegenden Ausführungsbeispielen zusätzlich Wärmesenken 50.2, welche in einem jeweiligen Leistungsbereich der Leiterplatte 10, 10' über beispielsweise Lötabstandsbumps kontaktiert sind. Manche der elektrischen und/oder elektronischen Bauelemente 50.1, beispielsweise Kondensatoren, stehen im Vergleich zu anderen stärker von der bestückten Leiterplattenseite ab. Durch das unterschiedliche Abstehen der elektrischen und/oder elektronischen Bauelemente 50, 50.1, 50.2 ist insgesamt eine Bestückungstopologie 55 der bestückten Leiterplattenseite ausgebildet (zur Vereinfachung in den Fig. 1b - 1d und in den Fig. 2b - 2d nicht mehr gezeigt).

In den Fig. 1b und 2b ist jeweils ein weiterer Verfahrensschritt zur Ausbildung der entsprechenden Ausführungsform der Elektronikeinheit 100, 100' gezeigt. Grundsätzlich wird dabei angrenzend zu zumindest einer bestückten Leiterplattenseite ein Einlegeformteil 60 angeordnet. Dieses kann bevorzugt als ein Spritzgussformteil, ein Hohlformkörper oder ein Formschaumkörper ausgebildet sein. Bevorzugt ist das Einlegeformteil 60 aus einem, insbesondere elektrisch isolierendem Kunststoffmaterial vorgesehen. Weiter bevorzugt ist das Einlegeformteil 60 einstückig ausgebildet. Alternativ kann ein solches Einlegeformteil 60 auch als ein Formteilverbund 60' vorliegen, umfassend ein Körperelement 60.1 und ein Körperelement 60.2 - wie nur schematisch in Fig.lb angedeutet. Beide Körperelemente 60.1, 60.2 sind über jeweils an den Körperelementseiten ausgebildeten Verbindungsabschnitten 60a mittels eines Form-, Kraft-oder Stoffschlusses miteinander starr verbunden.
Eine der bestückten Leiterplattenseite zugewandte Seite des Einlegeformteils 60 ist an die dort vorliegende Bestückungstopologie 55 angepasst. Des Weiteren ist zwischen den elektrischen und/oder elektronischen Bauelementen 50, 50.1, 50.2 bevorzugt ein Spaltabstand xl, x2 vorgesehen. In Bezug auf die in Fig. 2b dargestellte Ausführungsform ist das Einlegeformteil 60 gegenüber der Bestückungstopologie 55 jeweils einer Bestückungsseite der Leiterplatten 10', 20, 30 angepasst. Hierbei ist das Einlegeformteil 60 zwischen den Leiterplatten 10', 20 eingelegt. Das Einlegeformteil 60 gemäß der Fig. la ist keilförmig ausgebildet und an seiner Grundfläche der Bestückungstopologie der Leiterplatte 10 angepasst. Allgemein ist durch die Anpassungen an die Bestückungstopologie das Einlegeformteil 60 durch Anstoßen an elektrische und/oder elektronische Bauelemente 50, 50.1, 50.2 zumindest in seiner lateralen Verschiebungsmöglichkeit behindert. Bevorzugt weist ein solches Einlegeformteil eine Formgestalt von einfachen Körpern auf.

In den Fig. 1c und 2c ist jeweils ein nächster Verfahrensschritt gezeigt, welcher das Einlegen der zumindest einen Leiterplatte 10 oder der Anordnung 5, umfassend die Leiterplatten 10', 20, 30 zusammen mit dem entsprechenden Einlegeformteil 60 in ein einen Volumenkörper 200 der Elektronikeinheit 100, 100' ausformendes Werkzeug 150 vorsieht. Zwischen der Wandung des Werkzeuges 150 verbleibt dabei ein Freiraum als Füllvolumen 70 für eine Vergussmasse 80. Die Vergussmasse 80 wird in einem fließfähigen Zustand durch eine Einfüllöffnung des Werkzeuges 150 (nicht dargestellt) in den Freiraum eingebracht. Dabei nimmt das Einlegeformteil 60 gegenüber der einfließenden Vergussmasse 80 ein räumlich geschlossenes Verdrängungsvolumen 75 im Volumenkörper 200 ein. Die Vergussmasse 80 ist daher gezwungen, das Einlegeformteil 60 zu umfließen bis das Füllvolumen 70 vollständig durch die Vergussmasse 80 ausgefüllt ist. Indem die Vergussmasse 80' verfestigt wird, kommt es zur Ausbildung einer Schutzumhausung 90, in welcher die Leiterplatte 10 bzw. die Anordnung 5 der Leiterplatten 10', 20, 30 eingebettet ist.

Die Fig. 1d und 2d zeigen die erste und die weitere Ausführungsform der Elektronikeinheit 100, 100' in einem aus dem Werkzeug 150 entformten Zustand. Hierbei bildet die verfestigte Vergussmasse 80' die Außenfläche des jeweiligen Volumenkörpers 200 aus. Aus einem dieser Außenflächen tritt der Anschlusskontakt 40 heraus und bietet eine elektrische Kontaktierungsmöglichkeit der Elektronikeinheit 100, 100', beispielsweise in Form eines Steuergerätes, mit einem entsprechenden Gegenstecker.

Ferner sind weitere Ausführungsformen einer Elektronikeinheit angedeutet und zur Vereinfachung nur in den Fig. 1d und 2d gestrichelt dargestellt. Eine Ausführungsvariante ergibt sich beispielsweise dadurch, dass an beiden bestückten Seiten der Leiterplatte 10, 10' jeweils angrenzend ein Einlegeformteil 60 angeordnet ist. Dies ist beispielsweise erforderlich, weil auch an der zweiten bestückten Leiterplattenseite stark abstehende elektrische Bauelemente 50.1 herausragen oder eine ganz bestimmte Formgestalt der Elektronikeinheit 100, 100' umzusetzen ist. Zusätzlich oder unabhängig davon ist eine Ausführungsform der Elektronikeinheit 100 denkbar, bei welcher der Volumenkörper 200 zumindest einen Außenflächenteil aufweist, welcher durch einen Teilbereich 61 des Einlegeformteils 60 gebildet ist, wie in Fig. ld schematisch angedeutet. Der Teilbereich 61 des Einlegeformteils 60 umfasst beispielsweise Befestigungselemente 66 als Befestigungsmöglichkeit der Elektronikeinheit 100 mit einem Halter (nicht dargestellt).

## Patentansprüche

1. Elektronikeinheit (100, 100') umfassend zumindest eine ein- oder zweiseitig mit einer Vielzahl von elektrisch und/oder elektronischen Bauelementen (50, 50.1, 50.2) bestückte Leiterplatte (10, 10', 20), welche zumindest in einer Schutzumhausung (90) aus einer verfestigten Vergussmasse (80') eingebettet ist, wobei die Elektronikeinheit (100, 100') insgesamt einen Volumenkörper (200) ausbildet, in welchem die verfestigte Vergussmasse (80') ein Füllvolumen (70) einnimmt,
**dadurch gekennzeichnet, dass**
die Elektronikeinheit (100, 100') zur Minimierung des Füllvolumens (70) zusätzlich ein separates Einlegeformteil (60) umfasst, welches zumindest angrenzend zu einer bestückten Seite der zumindest einen Leiterplatte (10, 10', 20) angeordnet ist und gegenüber einer fließfähigen Vergussmasse (80) zur Ausbildung der Schutzumhausung (90) in einem verfestigten Zustand (80') ein räumlich geschlossenes Verdrängungsvolumen im Volumenkörper (200) einnimmt.

2. Elektronikeinheit (100, 100') nach Anspruch 1,
**dadurch gekennzeichnet, dass**
das Verdrängungsvolumen mindestens so groß ist wie das Füllvolumen (70), bevorzugt mehr als zweimal so groß.

3. Elektronikeinheit (100, 100') nach einem der Ansprüche 1 oder 2,
**dadurch gekennzeichnet, dass**
die bestückte Seite der zumindest einen Leiterplatte (10, 10', 20) eine Bestückungstopologie (55) aufweist, welche durch die von der bestückten Seite abstehenden elektrischen und/oder elektronischen Bauelemente (50, 50.1, 50.2) gekennzeichnet ist, wobei eine der bestückten Seite zugewandte Seite des Einlegeformteils (60) an die Bestückungstopologie (55) angepasste ist.

4. Elektronikeinheit (100, 100') nach einem der vorhergehenden Ansprüche,
**dadurch gekennzeichnet, dass**
zwischen dem Einlegeformteil (60) und der angrenzenden bestückten Seite der zumindest einen Leiterplatte (10, 10', 20) ein Spaltabstand (x1, x2) derart ausgebildet ist, dass die auf der bestückten Seite der Leiterplatte (10, 10', 20) angeordneten elektrischen und/oder elektronischen Bauelemente (50, 50.1, 50.1) vollständig von der Vergussmasse (80') eingeschlossen sind.

5. Elektronikeinheit (100, 100') nach einem der vorhergehenden Ansprüche,
**dadurch gekennzeichnet, dass**
in einer Draufsicht auf eine bestückte Seite der zumindest einen Leiterplatte (10, 10', 20) das Einlegeformteil (60) mehr als die Hälfte der Leiterplatte (10, 10', 20) überdeckt, bevorzugt in einer Überdeckung von 70% bis 100%.

6. Elektronikeinheit (100, 100') nach einem der vorhergehenden Ansprüche,
**dadurch gekennzeichnet, dass**
die Elektronikeinheit (100, 100') zwei übereinander angeordnete ein- oder zweiseitig bestückte Leiterplatten (10', 20) umfasst, wobei das Einlegeformteil (60) zwischen beiden Leiterplatten (10', 20) angeordnet ist.

7. Elektronikeinheit (100, 100') nach einem der vorhergehenden Ansprüche,
**dadurch gekennzeichnet, dass**
die zumindest eine Leiterplatte (10, 10', 20) beidseitig bestückt ist und zu beiden bestückten Seiten der Leiterplatte (10, 10', 20) jeweils angrenzend ein Einlegeformteil (60) angeordnet ist.

8. Elektronikeinheit (100, 100') nach einem der vorhergehenden Ansprüche,
**dadurch gekennzeichnet, dass**
das Einlegeformteil (60) einstückig ausgebildet ist oder aus einem zusammenhängenden Formteilverbund (60').

9. Elektronikeinheit (100, 100') nach einem der vorhergehenden Ansprüche,
**dadurch gekennzeichnet, dass**
das das Einlegeformteil (60) ein Hohlformkörper oder ein Formschaumkörper ist.

10. Elektronikeinheit (100, 100') nach einem der vorhergehenden Ansprüche,
**dadurch gekennzeichnet, dass**
das Einlegeformteil (60) aus einem elektrisch isolierenden Material ist.

11. Elektronikeinheit (100, 100') nach einem der vorhergehenden Ansprüche,
**dadurch gekennzeichnet, dass**
der Volumenkörper (200) und/oder das Einlegeformteil (60) jeweils als ein Polyeder ausgebildet ist/sind, insbesondere als Würfel, Quader, Tetraeder, Pyramide, Pyramidenstumpf, Oktaeder, oder als Rotationskörper oder Kugel oder Kugelkalotte oder Zylinder oder Ellipsoid oder Kegel oder Kegelstumpf.

12. Elektronikeinheit (100, 100') nach einem der vorhergehenden Ansprüche,
**dadurch gekennzeichnet, dass**
der Volumenkörper (200) zumindest einen Außenflächenteil aufweist, welcher durch einen Teilbereich (61) des Einlegeformteils (60) gebildet ist.

13. Elektronikeinheit (100, 100') nach Anspruch 12,
**dadurch gekennzeichnet, dass**
der Teilbereich (61) des Einlegeformteils (60) Befestigungselemente (66) umfasst als Befestigungsmöglichkeit der Elektronikeinheit (100, 100') mit einem Halter.

14. Elektronikeinheit (100, 100') nach einem der vorhergehenden Ansprüche,
**dadurch gekennzeichnet, dass**
die Elektronikeinheit (100, 100') einen Anschlussstecker (40) umfasst, welcher mit der Leiterplatte (10, 30) elektrisch kontaktiert ist und von außerhalb des Volumenkörpers (200) durch einen Gegenstecker (40) kontaktierbar ist.

15. Verfahren zur Ausbildung einer Elektronikeinheit (100, 100'), insbesondere nach einem der vorhergehenden Ansprüche, umfassend zumindest eine ein- oder zweiseitig mit einer Vielzahl von elektrisch und/oder elektronischen Bauelementen (50, 50.1, 50.2) bestückte Leiterplatte (10, 10', 20) mit den Verfahrensschritten:
- Einlegen der zumindest einen Leiterplatte (10, 10', 20) zusammen mit einem Einlegeformteil (60) in ein einen Volumenkörper (200) der Elektronikeinheit (100, 100') ausformendes Werkzeug (150), wobei das Einlegeformteil (60) angrenzend zu der zumindest einen bestückten Seite angeordnet wird und im Werkzeug (150) ein Freiraum als Füllvolumen (70) für eine Vergussmasse (80) verbleibt,
- Einbringen einer fließfähigen Vergussmasse (80) in das Werkzeug bis zum vollständigen Ausfüllen des Füllvolumens (70) durch Vergussmasse (80),
- Ausbilden einer Schutzumhausung (90), in welcher die Leiterplatte (10, 10', 20) eingebettet ist, indem die Vergussmasse (80') verfestigt wird und die verfestigte Vergussmasse (80') zumindest einen Teil der Außenfläche des Volumenkörpers (200) ausbildet.

## Claims

1. Electronic unit (100, 100') comprising at least one printed circuit board (10, 10', 20) which is populated on one or two sides with a multiplicity of electrical and/or electronic components (50, 50.1, 50.2) and is embedded at least in a protective housing (90) made of a solidified encapsulation compound (80'), the electronic unit (100, 100') overall forming a volume body (200) in which the solidified encapsulation compound (80') occupies a filling volume (70),
**characterized in that**
in order to minimize the filling volume (70), the electronic unit (100, 100') additionally comprises a separate shaped insertion part (60) which is arranged at least adjacent to a populated side of the at least one printed circuit board (10, 10', 20) and occupies a spatially closed displacement volume in the volume body (200) in relation to a flowable encapsulation compound (80) for forming the protective housing (90) in a solidified state (80').

2. Electronic unit (100, 100') according to Claim 1,
**characterized in that**
the displacement volume is at least as large as the filling volume (70), preferably more than two times as large.

3. Electronic unit (100, 100') according to either of Claims 1 and 2,
**characterized in that**
the populated side of the at least one printed circuit board (10, 10', 20) has a population topology (55) which is **characterized by** the electrical and/or electronic components (50, 50.1, 50.2) protruding from the populated side, a side of the shaped insertion part (60) facing toward the populated side being adapted to the population topology (55).

4. Electronic unit (100, 100') according to one of the preceding claims,
**characterized in that**
a gap distance (x1, x2) between the shaped insertion part (60) and the adjacent populated side of the at least one printed circuit board (10, 10', 20) is configured in such a way that the electrical and/or electronic components (50, 50.1, 50.1) arranged on the populated side of the printed circuit board (10, 10', 20) are fully enclosed by the encapsulation compound (80').

5. Electronic unit (100, 100') according to one of the preceding claims,
**characterized in that**
in a plan view of a populated side of the at least one printed circuit board (10, 10', 20), the shaped insertion part (60) covers more than half of the printed circuit board (10, 10', 20), preferably in a coverage of from 70% to 100%.

6. Electronic unit (100, 100') according to one of the preceding claims,
**characterized in that**
the electronic unit (100, 100') comprises two printed circuit boards (10', 20) populated on one or two sides and arranged above one another, the shaped insertion part (60) being arranged between the two printed circuit boards (10', 20).

7. Electronic unit (100, 100') according to one of the preceding claims,
**characterized in that**
the at least one printed circuit board (10, 10', 20) is populated on both sides, and a shaped insertion part (60) is respectively arranged adjacent to the two populated sides of the printed circuit board (10, 10', 20).

8. Electronic unit (100, 100') according to one of the preceding claims,
**characterized in that**
the shaped insertion part (60) is formed in one piece or made of a continuous shaped part assembly (60').

9. Electronic unit (100, 100') according to one of the preceding claims,
**characterized in that**
the shaped insertion part (60) is a hollow shaped body or a shaped foam body.

10. Electronic unit (100, 100') according to one of the preceding claims,
**characterized in that**
the shaped insertion part (60) is made of an electrically insulating material.

11. Electronic unit (100, 100') according to one of the preceding claims,
**characterized in that**
the volume body (200) and/or the shaped insertion part (60) is/are respectively formed as a polyhedron, in particular as a cube, cuboid, tetrahedron, pyramid, pyramidal frustum, octahedron, or as a body of rotation or sphere or spherical cap or cylinder or ellipsoid or cone or conic frustum.

12. Electronic unit (100, 100') according to one of the preceding claims,
**characterized in that**
the volume body (200) has at least one outer face part which is formed by a subregion (61) of the shaped insertion part (60).

13. Electronic unit (100, 100') according to Claim 12,
**characterized in that**
the subregion (61) of the shaped insertion part (60) comprises fastening elements (66) as a way of fastening the electronic unit (100, 100') to a holder.

14. Electronic unit (100, 100') according to one of the preceding claims,
**characterized in that**
the electronic unit (100, 100') comprises a connection jack (40), which is electrically contacted with the printed circuit board (10, 30) and can be contacted from outside the volume body (200) by a mating jack (40).

15. Method for forming an electronic unit (100, 100'), in particular according to one of the preceding claims, comprising at least one printed circuit board (10, 10', 20) which is populated on one or two sides with a multiplicity of electrical and/or electronic components (50, 50.1, 50.2), having the method steps:
- inserting the at least one printed circuit board (10, 10', 20) together with a shaped insertion part (60) into a tool (150) that shapes a volume body (200) of the electronic unit (100, 100'), the shaped insertion part (60) being arranged adjacent to the at least one populated side, and a free space as a filling volume (70) for an encapsulation compound (80) remaining in the tool (150),
- introducing a flowable encapsulation compound (80) into the tool until the filling volume (70) is fully filled with encapsulation compound (80),
- forming a protective housing (90) in which the printed circuit board (10, 10', 20) is embedded, by the encapsulation compound (80') being solidified and the solidified encapsulation compound (80') forming at least a part of the outer face of the volume body (200).

## Revendications

1. Unité électronique (100, 100') comprenant au moins un circuit imprimé (10, 10', 20) équipé sur une ou deux faces d'une pluralité de composants (50, 50.1, 50.2) électriques et/ou électroniques, lequel est enrobé au moins dans une enceinte de protection (90) en une masse de scellement (80') durcie, l'unité électronique (100, 100') formant globalement un corps volumique (200) dans lequel la masse de scellement (80') occupe un volume de remplissage (70),
**caractérisée en ce que**
l'unité électronique (100, 100'), en vue de réduire au minimum le volume de remplissage (70), comporte en plus une pièce moulée à insérer (60) séparée, laquelle est disposée au moins adjacente d'une face équipée de l'au moins un circuit imprimé (10, 10', 20) et occupe dans le corps volumique (200) un volume de substitution fermé dans l'espace par rapport à une masse de scellement (80) coulante destinée à former l'enceinte de protection (90) à l'état durci (80').

2. Unité électronique (100, 100') selon la revendication 1, **caractérisée en ce que** le volume de substitution est au moins de la même taille que le volume de remplissage (70), de préférence plus du double de sa taille.

3. Unité électronique (100, 100') selon l'une des revendications 1 et 2, **caractérisée en ce que** la face équipée de l'au moins un circuit imprimé (10, 10', 20) possède une topologie d'équipement (55) qui est **caractérisée par** les composants (50, 50.1, 50.2) électriques et/ou électroniques faisant saillie depuis la face équipée, un côté de la pièce moulée à insérer (60) qui fait face à la face équipée étant adapté à la topologie d'équipement (55).

4. Unité électronique (100, 100') selon l'une des revendications précédentes, **caractérisée en ce qu'**entre la pièce moulée à insérer (60) et la face équipée adjacente de l'au moins un circuit imprimé (10, 10', 20) est configurée une distance d'intervalle (x1, x2) de telle sorte que les composants (50, 50.1, 50.1) électriques et/ou électroniques disposés sur la face équipée du circuit imprimé (10, 10', 20) sont entièrement enfermés par la masse de scellement (80').

5. Unité électronique (100, 100') selon l'une des revendications précédentes, **caractérisée en ce que** dans une vue de dessus sur une face équipée de l'au moins un circuit imprimé (10, 10', 20), la pièce moulée à insérer (60) recouvre plus de la moitié du circuit imprimé (10, 10', 20), de préférence dans un taux de recouvrement de 70 % à 100 %.

6. Unité électronique (100, 100') selon l'une des revendications précédentes, **caractérisée en ce que** l'unité électronique (100, 100') comporte deux circuits imprimés (10', 20) équipés sur une ou deux faces disposés l'un au-dessus de l'autre, la pièce moulée à insérer (60) étant disposée entre les deux circuits imprimés (10', 20).

7. Unité électronique (100, 100') selon l'une des revendications précédentes, **caractérisée en ce que** l'au moins un circuit imprimé (10, 10', 20) est équipé sur les deux faces et une pièce moulée à insérer (60) est respectivement disposée adjacente aux deux faces équipées du circuit imprimé (10, 10', 20).

8. Unité électronique (100, 100') selon l'une des revendications précédentes, **caractérisée en ce que** la pièce moulée à insérer (60) est réalisée monobloc ou se compose d'un assemblage de pièces moulées (60') contiguës.

9. Unité électronique (100, 100') selon l'une des revendications précédentes, **caractérisée en ce que** la pièce moulée à insérer (60) est un corps moulé creux ou un corps alvéolaire moulé.

10. Unité électronique (100, 100') selon l'une des revendications précédentes, **caractérisée en ce que** la pièce moulée à insérer (60) est constituée d'un matériau électriquement isolant.

11. Unité électronique (100, 100') selon l'une des revendications précédentes, **caractérisée en ce que** le corps volumique (200) et/ou la pièce moulée à insérer (60) est/sont respectivement réalisé(s) sous la forme d'un polyèdre, notamment un cube, un parallélépipède, un tétraèdre, une pyramide, une pyramide tronquée, un octaèdre, ou sous la forme d'un corps rotatif ou d'une bille ou d'une calotte sphérique ou d'un cylindre ou d'un ellipsoïde ou d'un cône ou d'un cône tronqué.

12. Unité électronique (100, 100') selon l'une des revendications précédentes, **caractérisée en ce que** le corps volumique (200) possède au moins une partie de surface extérieure qui est formée par une zone partielle (61) de la pièce moulée à insérer (60).

13. Unité électronique (100, 100') selon la revendication 12, **caractérisée en ce que** la zone partielle (61) de la pièce moulée à insérer (60) comporte des éléments de fixation (66) en tant que possibilité de fixation de l'unité électronique (100, 100') avec un support.

14. Unité électronique (100, 100') selon l'une des revendications précédentes, **caractérisée en ce que** l'unité électronique (100, 100') comporte une fiche de raccordement (40), laquelle est mise en contact électrique avec le circuit imprimé (10, 30) et avec laquelle le contact peut être établi depuis l'extérieur du corps volumique (200) par une fiche homologue (40).

15. Procédé de formation d'une unité électronique (100, 100'), notamment selon l'une des revendications précédentes, comprenant au moins un circuit imprimé (10, 10', 20) équipé sur une ou deux faces d'une pluralité de composants (50, 50.1, 50.2) électriques et/ou électroniques, comprenant les étapes suivantes :
- insertion de l'au moins un circuit imprimé (10, 10', 20), conjointement avec une pièce moulée à insérer (60), dans un outil (150) qui façonne un corps volumique (200) de l'unité électronique (100, 100'), la pièce moulée à insérer (60) étant disposée adjacente à l'au moins une face équipée et un espace libre restant dans l'outil (150) en tant que volume de remplissage (70) pour une masse de scellement (80),
- introduction d'une masse de scellement (80) coulante dans l'outil jusqu'au remplissage complet du volume de remplissage (70) avec la masse de scellement (80),
- formation d'une enceinte de protection (90) dans laquelle est enrobé le circuit imprimé (10, 10', 20) en faisant durcir la masse de scellement (80') et la masse de scellement (80') durcie forme au moins une partie de la surface extérieure du corps volumique (200).
